# EUROPEAN PATENT SPECIFICATION

(11) **EP 4 415 044 B1**
(45) Date of publication and mention of the grant of the patent: **29.04.2026**
(21) Application number: 23806511.4
(22) Date of filing: 19.01.2023
(51) Int. Cl.: G02F 1/1333, G02F 1/1362, H01L 23/60, G09F 9/35, G09F 9/33

(54) **DISPLAY MODULE AND DISPLAY APPARATUS**
ANZEIGEMODUL UND ANZEIGEVORRICHTUNG
MODULE D'AFFICHAGE ET APPAREIL D'AFFICHAGE

(30) Priority: 18.05.2022 CN 202221206402 U
(43) Date of publication of application: 14.08.2024
(73) Proprietor: Honor Device Co., Ltd., Shenzhen, Guangdong 518040 (CN)
(72) Inventor: ZHOU, Yongshan, Guangdong 518040 (CN); YUAN, Gao, Guangdong 518040 (CN)
(74) Representative: Gill Jennings & Every LLP
(86) International application number: PCT/CN2023/073161
(87) International publication number: WO 2023/221549

(56) References cited:
- CN-A- 113 112 927
- CN-A- 113 257 138
- CN-A- 113 257 138
- CN-A- 113 362 723
- CN-A- 113 362 724
- CN-A- 113 903 260
- CN-U- 218 274 593
- JP-A- 2015 129 862

## Description

This application claims priority to Chinese Patent Application No. 202221206402.3, filed with the China National Intellectual Property Administration on May 18, 2022 and entitled "DISPLAY MODULE AND DISPLAY APPARATUS".

### TECHNICAL FIELD

This application relates to the field of display technologies, and in particular, to a display module and a display apparatus.

### BACKGROUND

A display module includes a display panel and a cover plate located on a display side of the display panel. During use of the display module, static electricity may be generated on a surface of the cover plate. For example, when the cover plate rubs against a finger or clothing of a user, a large quantity of electrostatic charges are generated on the surface of the cover plate. The electrostatic charges are conducted along a packaging adhesive at an edge of the display module to a side surface of the display module, and the electrostatic charges accumulate at the edge of the display module, which easily causes an edge of the display panel to turn green during display that is performed by the display module. As a result, a display effect of the display module is poor. CN113257138A discloses a display module comprising a support film with a first adhesive layer and a graphene layer forming a low-impedance stack, with optional additional layers including an organic layer, a heat dissipation film, conductive layers, and buffer layers. CN113362724A discloses a display module comprising a display panel, back film, adhesive layer with through-holes, heat dissipation layer, and conductive parts within the holes to connect the back film and heat dissipation layer.

### SUMMARY

Embodiments of this application provide a display module and a display apparatus, to resolve a technical problem of greening of a display panel.

To achieve the foregoing objective, the following technical solutions are used in the embodiments of this application:
According to a first aspect, this application provides a display module. The display module includes a display panel, a back plane film, a buffer layer, and an electrostatic discharge layer. The display panel has a display side and a non-display side disposed opposite to each other; the back plane film is located on the non-display side of the display panel; the buffer layer is located on a side that is of the back plane film and that is away from the display panel; and the electrostatic discharge layer is located on a side that is of the buffer layer and that is away from the display panel. An impedance of the buffer layer is less than an impedance of the back plane film, and at least a part of a surface of the buffer layer is in direct contact with the electrostatic discharge layer. The buffer layer is conductive silica gel.

According to the display module provided in this embodiment of this application, the impedance of the buffer layer is set to be lower than the impedance of the back plane film, and at least a part of the surface of the buffer layer is in direct contact with the electrostatic discharge layer. In this way, electrostatic charges entering a side surface of the display module enter the buffer layer easily. Because at least a part of the surface of the buffer layer is in direct contact with the electrostatic discharge layer, an electrostatic discharge path can be formed between the buffer layer and the electrostatic discharge layer, so that the electrostatic charges in the buffer layer can be smoothly transmitted to the electrostatic discharge layer through a contact surface on which the buffer layer is in direct contact with the electrostatic discharge layer, and are discharged by using the electrostatic discharge layer. Therefore, the electrostatic charges are prevented from accumulating at a film layer of the display module, to prevent the electrostatic charges from interfering with a drive circuit of the display module, thereby resolving a problem of greening of the display module.

In a possible design manner of the first aspect, at least a part of the surface of the buffer layer is in direct contact with the back plane film. In this way, an electrostatic discharge path can be formed between the back plane film, the buffer layer, and the electrostatic discharge layer, so that electrostatic charges accumulated on the back plane film can be transmitted to the electrostatic discharge layer by using the buffer layer and are discharged. Therefore, accumulation of the electrostatic charges on the back plane film is further avoided, to prevent the electrostatic charges from interfering with a circuit on a drive side of the display panel.

The conductive silica gel means distributing conductive particles such as silver-coated copper powder, nickel-coated graphite powder, organic chelation, and metal chelation in silica gel, and being conducted through mutual contact between the conductive particles to achieve good conductive performance. In other words, the buffer layer in this embodiment includes silica gel and conductive particles, and the conductive particles are distributed in the silica gel. Optionally, the conductive particles are evenly distributed in the silica gel. In this way, the conductive silica gel is used as the buffer layer, so that not only an electrostatic grounding path can be formed between the buffer layer and the electrostatic discharge layer through connection between the buffer layer and the electrostatic discharge layer, but also the display module can be effectively protected. A structure is simple, a design is ingenious, and costs of the conductive silica gel are low, so that costs of the display module can be effectively reduced.

In a possible design manner of the first aspect, the buffer layer has a first surface and a second surface disposed opposite to each other in a thickness direction of the buffer layer, and the first surface is in direct contact with and fastened through bonding to a surface on a side that is of the electrostatic discharge layer and that faces the display panel. In this way, the buffer layer can be fixedly connected to the electrostatic discharge layer through viscosity of the buffer layer (that is, the conductive silica gel), so that a pressure sensitive adhesive used to bond the buffer layer and the electrostatic discharge layer can be omitted, thereby helping reduce an overall thickness of the display module.

In a possible design manner of the first aspect, the buffer layer has the first surface and the second surface disposed opposite to each other in the thickness direction of the buffer layer, and the second surface is in direct contact with and fastened through bonding to a surface on the side that is of the back plane film and that is away from the display panel. In this way, the buffer layer can be fixedly connected to the back plane film through viscosity of the buffer layer (that is, the conductive silica gel), so that a pressure sensitive adhesive used to bond the buffer layer and the back plane film can be omitted, thereby helping reduce an overall thickness of the display module. In addition, the surface on the side that is of the back plane film and that is away from the display panel is in direct contact with the second surface of the buffer layer, so that an electrostatic grounding path can be formed between the back plane film, the buffer layer, and the electrostatic discharge layer, and electrostatic charges accumulated on the back plane film can be transmitted to the electrostatic discharge layer by using the buffer layer and are discharged.

In a possible design manner of the first aspect, the buffer layer has a first surface and a second surface disposed opposite to each other in a thickness direction of the buffer layer, the first surface is in direct contact with and fastened through bonding to a surface on a side that is of the electrostatic discharge layer and that faces the display panel, and the second surface is in direct contact with and fastened through bonding to a surface on the side that is of the back plane film and that is away from the display panel. In this way, the buffer layer can be fixedly connected to the electrostatic discharge layer through viscosity of the buffer layer (that is, the conductive silica gel), and the buffer layer can be fixedly connected to the back plane film through viscosity of the buffer layer (that is, the conductive silica gel), so that a pressure sensitive adhesive used to bond the buffer layer and the electrostatic discharge layer and a pressure sensitive adhesive used to bond the buffer layer and the back plane film can be omitted, thereby helping reduce an overall thickness of the display module. In addition, the surface on the side that is of the back plane film and that is away from the display panel is in direct contact with the second surface of the buffer layer, so that an electrostatic grounding path can be formed between the back plane film, the buffer layer, and the electrostatic discharge layer, and electrostatic charges accumulated on the back plane film can be transmitted to the electrostatic discharge layer by using the buffer layer and are discharged.

In a possible design manner of the first aspect, the buffer layer has a first surface and a second surface disposed opposite to each other in a thickness direction of the buffer layer, an orthographic projection of the first surface on a plane in which the electrostatic discharge layer is located is a first projection, the first projection and the electrostatic discharge layer have a first overlapping region, and a part that is of the first surface and that corresponds to the first overlapping region is in direct contact with the electrostatic discharge layer. In this way, a contact area between the buffer layer and the electrostatic discharge layer can be increased, so that in one aspect, electrostatic discharge efficiency can be improved, and in another aspect, reliability of connection between the buffer layer and the electrostatic discharge layer can be improved.

In a possible design manner of the first aspect, the buffer layer has a first surface and a second surface disposed opposite to each other in a thickness direction of the buffer layer, an orthographic projection of the second surface on a plane in which the back plane film is located is a second projection, the second projection and the back plane film have a second overlapping region, and a part that is of the second surface and that corresponds to the first overlapping region is in direct contact with the back plane film. In this way, a contact area between the buffer layer and the back plane film can be increased, so that in one aspect, electrostatic discharge efficiency can be improved, and in another aspect, reliability of connection between the buffer layer and the back plane film can be improved.

In a possible design manner of the first aspect, a concave-convex structure is disposed on a surface on a side that is of the buffer layer and that faces the back plane film. In this way, bubbles can be prevented from being generated in a process of bonding the conductive silica gel and the back plane film, thereby preventing defects such as bulges from occurring on the back plane film.

In a possible design manner of the first aspect, a convex part protruding from the second surface or a groove part is disposed on the second surface of the buffer layer.

In a possible design manner of the first aspect, the impedance of the buffer layer is greater than an impedance of the electrostatic discharge layer. In this way, a conductive gradient can be formed between the buffer layer and the electrostatic discharge layer, so that an electrostatic dissipation gradient may be formed between the buffer layer and the electrostatic discharge layer, thereby helping improve electrostatic dissipation efficiency and avoid greening of the display module. In addition, the impedance of the buffer layer is set to be greater than the impedance of the electrostatic discharge layer to ensure that a charge dissipation layer, that is, the electrostatic discharge layer, that plays a main role is away from the display panel, so as to prevent an electrostatic dissipation process from causing a disturbance or another impact on a thin film transistor in the display panel, thereby helping further improve performance of the display module.

In a possible design manner of the first aspect, the impedance of the buffer layer is greater than or equal to 10³ Ω and less than or equal to 10⁶ Ω.

In a possible design manner of the first aspect, a thickness of the buffer layer is greater than or equal to 0.05 mm and less than or equal to 0.15 mm. In this way, a thickness of the display module can be reduced while a buffer function of the buffer layer is ensured, which helps implement a lightening and thinning design of a display apparatus.

In a possible design manner of the first aspect, the thickness of the buffer layer is greater than or equal to 0.08 mm and less than or equal to 0.12 mm. In this way, a thickness of the display module can be reduced while a buffer function of the buffer layer is ensured, which helps implement a lightening and thinning design of a display apparatus.

In a possible design manner of the first aspect, the electrostatic discharge layer is a metal layer.

In a possible design manner of the first aspect, the display module further includes a polarizer, and the polarizer is located on the display side of the display panel.

In a possible design manner of the first aspect, the display module further includes a light-transmissive cover plate, the light-transmissive cover plate is disposed on a side that is of the polarizer and that is away from the display panel, and the light-transmissive cover plate is connected through bonding to the polarizer through a transparent optically clear adhesive.

According to a second aspect, this application provides a display apparatus, including a display panel, a back plane film, a buffer layer, an electrostatic discharge layer, and a conductive part. The display panel has a display side and a non-display side disposed opposite to each other; the back plane film is located on the non-display side of the display panel; the buffer layer is located on a side that is of the back plane film and that is away from the display panel; the electrostatic discharge layer is located on a side that is of the buffer layer and that is away from the display panel, and an impedance of the buffer layer is less than an impedance of the back plane film; and one end of the conductive part is connected to the buffer layer, and the other end of the conductive part is connected to the electrostatic discharge layer. The buffer layer is conductive silica gel.

In this way, an electrostatic discharge path can be formed between the buffer part, the conductive part, and the electrostatic discharge layer, so that electrostatic charges can be conveniently discharged.

In a possible implementation of the second aspect, the conductive part is located between a first surface of the buffer layer and a surface on a side that is of the electrostatic discharge layer and that faces the buffer layer.

In a possible implementation of the second aspect, the conductive part is a conductive adhesive.

In a possible implementation of the second aspect, a first surface of the buffer layer is fixedly connected to the electrostatic discharge layer by using a fifth bonding layer, and the conductive part is connected between a side wall surface of the buffer layer and a side wall surface of the electrostatic discharge layer.

In a possible implementation of the second aspect, a first surface of the buffer layer is fixedly connected to the electrostatic discharge layer by using a fifth bonding layer, and the conductive part is inserted between the buffer layer and the electrostatic discharge layer.

According to a third aspect, this application provides a display module, including a display panel, a back plane film, and a buffer layer. The display panel has a display side and a non-display side disposed opposite to each other; the back plane film is located on the non-display side of the display panel; and the buffer layer is located on a side that is of the back plane film and that is away from the display panel. An impedance of the buffer layer is less than an impedance of the back plane film, and the buffer layer is suitable for grounding. In this way, electrostatic charges entering a side surface of the display module enter the buffer layer easily. Because the buffer layer is grounded, the electrostatic charges at the buffer layer can be directly discharged by using the buffer layer. Therefore, the electrostatic charges are prevented from accumulating at a film layer of the display module, to prevent the electrostatic charges from interfering with a drive circuit of the display module, thereby resolving a problem of greening of the display module.

According to a fourth aspect, this application provides a display apparatus, including a display module. The display module is the display module in any one of the foregoing solutions, and the electrostatic discharge layer is grounded.

In a possible design manner of the fourth aspect, the display apparatus further includes a back housing, the back housing includes a back cover and a frame, the frame is disposed around an edge of the frame for one circle, the display module is disposed on the back housing, and the display module is disposed opposite to the back cover.

In a possible design manner of the fourth aspect, the back housing further includes a middle plate, the middle plate is fixedly connected to an inner surface of the frame, a grounding point is disposed on the middle plate, and the electrostatic discharge layer is electrically connected to the grounding point.

In a possible design manner of the fourth aspect, the display apparatus further includes a circuit board, the circuit board is disposed in the back housing, a grounding point is disposed on the circuit board, and the electrostatic discharge layer is electrically connected to the grounding point.

According to a fifth aspect, this application provides a display panel processing method, including: fastening a back plane film on a non-display side of the display panel; fastening the buffer layer on an electrostatic discharge layer; and fastening the buffer layer on a surface on a side that is of the back plane film and that is away from the display panel.

According to the display panel processing method provided in this embodiment of this application, a process is simple and processing is performed conveniently.

In a possible design manner of the fifth aspect, the conductive silica gel is fastened on the electrostatic discharge layer through scrape coating, which helps reduce an overall thickness of the display module.

### BRIEF DESCRIPTION OF DRAWINGS

FIG. 1 is a schematic diagram of a structure of a display apparatus according to some embodiments of this application;
FIG. 2 is a sectional view of the display apparatus shown in FIG. 1 at a line A-A;
FIG. 3 is a partial sectional view of a display module according to some embodiments of this application;
FIG. 4 is a partial sectional view of a polarizer in the display module shown in FIG. 3;
FIG. 5 is a partial sectional view of a display panel in the display module shown in FIG. 3;
FIG. 6 is a schematic diagram of assembly of the display panel shown in FIG. 5 and the polarizer shown in FIG. 4;
FIG. 7 is a schematic diagram of assembly of a back plane film, a display panel, and a polarizer in the display module shown in FIG. 3;
FIG. 8 is a schematic diagram of assembly of a buffer foam, a back plane film, a display panel, and a polarizer in the display module shown in FIG. 3;
FIG. 9 is a schematic diagram of assembly of an electrostatic discharge layer, a buffer foam, a back plane film, a display panel, and a polarizer in the display module shown in FIG. 3;
FIG. 10 is a partial sectional view of a display module according to some other embodiments of this application;
FIG. 11 is a schematic diagram of assembly of a back plane film, a buffer layer, and an electrostatic discharge layer in the display module shown in FIG. 10;
FIG. 12 is a schematic diagram of scrape coating conductive silica gel on an electrostatic discharge layer by using a scraper-type coating machine;
FIG. 13 is a schematic diagram of a partial structure of a buffer layer according to some embodiments of this application;
FIG. 14 is a schematic diagram of a partial structure of a buffer layer according to some other embodiments of this application;
FIG. 15 is a partial sectional view of a display module according to some other embodiments of this application;
FIG. 16 is a partial sectional view of a display module according to still some other embodiments of this application;
FIG. 17 is a partial sectional view of a display module according to still some other embodiments of this application;
FIG. 18 is a partial sectional view of a display module according to still some other embodiments of this application; and
FIG. 19 is a partial sectional view of a display module according to still some other embodiments of this application.

Reference numerals:
1000. display apparatus;
100. display module; 101. light-transmissive cover plate;
102. display screen; 102a. display side; 102b. non-display side; 1021. polarizer; 1021a. polyvinyl alcohol film; 1021b. tricellulose acetate film; 1022. display panel; 1022a. underlay substrate; 1022b. thin film transistor device layer; 1022c. light-emitting unit; 1023. back plane film; 1024. buffer foam; 1025. electrostatic discharge layer; 1025a. second flanged part; 1026. buffer layer; 1026a. first surface; 1026b. second surface; 1026c. first side wall surface; 1026d. concave-convex structure; 1026e. convex part; 1026f. groove part; 1026g. first flanged part; 1027. transparent optically clear adhesive; 1028. conductive part;
103. caulking adhesive;
200. back housing; 201. back cover; 202. frame;
300. middle plate; 301. sinking station;
400. circuit board; 401. primary circuit board; 402. secondary circuit board;
500. battery;
601. first bonding layer; 602. second bonding layer; 603. third bonding layer; 604. fourth bonding layer; 605. fifth bonding layer;
700. scraper-type coating machine;
701. workbench; 702. scraper; and 703. heating apparatus.

### DESCRIPTION OF EMBODIMENTS

In the embodiments of this application, words such as "example" or "for example" are used to represent giving an example, an illustration, or a description. Any embodiment or design solution described as "example" or "for example" in the embodiments of this application should not be construed as being more preferred or advantageous than other embodiments or design solutions. Exactly, the words such as "example" or "for example" are used to present related concepts in a specific manner.

In the embodiments of this application, the terms "first" and "second" are merely used for the purpose of description, and should not be understood as an indication or implication of relative importance or an implicit indication of a quantity of indicated technical features. Therefore, a feature defined with "first" or "second" may explicitly or implicitly include one or more of the features.

In the description of the embodiments of this application, "at least one" means one or more, and "a plurality of" means two or more. "At least one of the following items" or a similar expression thereof means any combination of these items, including a single item or any combination of a plurality of items. For example, at least one of a, b, or c may indicate a, b, c, a-b, a-c, b-c, or a-b-c, where a, b, and c may be singular or plural.

In the description of the embodiments of this application, the term "and/or" refers to and covers any of and all possible combinations of one or more associated listed items. The term "and/or" is an association relationship that describes associated objects, and indicates that three relationships may exist. For example, "A and/or B" may indicate the following three cases: Only A exists, both A and B exist, and only B exists. In addition, the character "/" in this application usually indicates an "or" relationship between associated objects.

In the description of the embodiments of this application, it should be noted that unless otherwise specified and defined explicitly, the terms "install", "connect", and "connection" should be understood in a broad sense. For example, "connection" may be a detachable connection or a non-detachable connection; or may be a direct connection or an indirect connection through an intermediate medium. A "fixed connection" means that components are connected to each other and a relative location relationship remains unchanged after the connection.

In the description of the embodiments of this application, unless otherwise specified and defined explicitly, the terms "install", "connect", and "connection" should be understood in a broad sense. For example, "connection" may be a detachable connection or a non-detachable connection; or may be a direct connection or an indirect connection through an intermediate medium. Orientation terms such as "inside" and "outside" mentioned in the embodiments of this application are merely directions in the accompanying drawings. Therefore, the used orientation terms are intended for better and clearer description and understanding of the embodiments of this application, and are not intended for indicating or implying that an indicated apparatus or element needs to have a specific orientation or constructed and operated in a specific orientation, and therefore shall not be construed as limitations on the embodiments of this application.

In the description of the embodiments of this application, the term "include", "have", or any other variant thereof is intended to cover non-exclusive inclusion, so that a process, method, article, or apparatus that includes a series of elements includes not only those elements but also other elements that are not explicitly listed, or further includes elements inherent to such a process, method, article, or apparatus. Without further limitation, the element defined by the sentence "including a ... " does not exclude that other identical elements also exist in the process, method, article, or apparatus including the element. Without further limitation, the element defined by the sentence "including a ..." does not exclude that other identical elements also exist in the process, method, article, or apparatus including the element.

This application provides a display apparatus 1000, and the display apparatus 1000 includes a display module 100. The display apparatus 1000 may be a product or a component that has any display function, such as a mobile phone, a tablet computer, a display, a television, a digital photo frame, a personal digital assistant (personal digital assistant, PDA), a notebook computer, an in-vehicle computer, a navigator, automobile audio, a wearable device, or the like. The wearable device includes but is not limited to a smart band, a smartwatch, a smart head-mounted display, smart glasses, or the like.

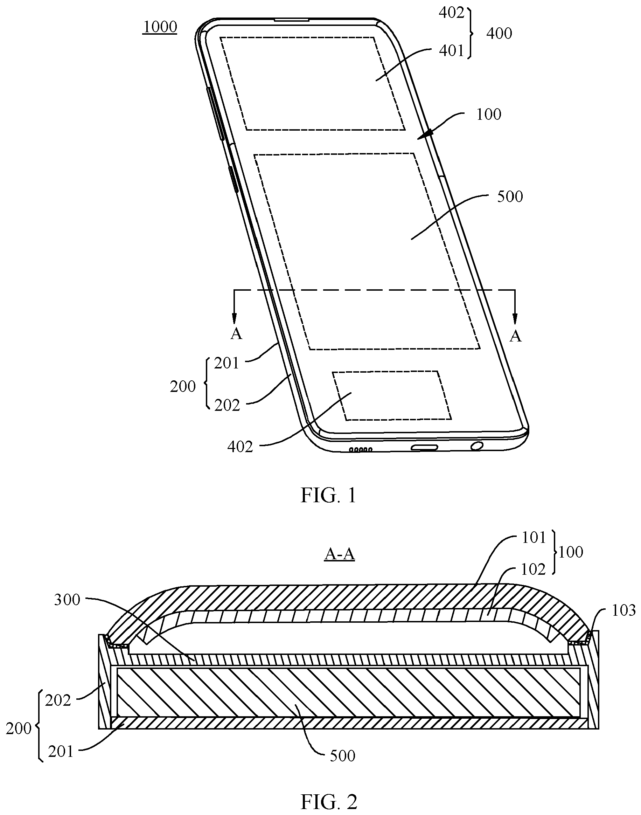

Referring to FIG. 1, FIG. 1 is a schematic diagram of a structure of a display apparatus 1000 according to some embodiments of this application. In this embodiment, the display apparatus 1000 is a phablet. Specifically, the display apparatus 1000 includes a display module 100, a back housing 200, a circuit board 400, and a battery 500. The circuit board 400 and the battery 500 are located inside the display apparatus 1000. Therefore, contours of the circuit board and the battery are shown by dashed lines. It may be understood that, in another embodiment, the display apparatus 1000 may alternatively be a mobile phone with a foldable screen.

It may be understood that, FIG. 1 and the following related accompanying drawings schematically show only some components included in the display apparatus 1000, and actual shapes, actual sizes, actual locations, and actual structures of the components are not defined by FIG. 1 and the following accompanying drawings.

In the embodiment shown in FIG. 1, the display apparatus 1000 is in a shape of a rectangular flat plate. In some other embodiments, the display apparatus 1000 may alternatively be in a shape of a square flat plate, a shape of a circular flat plate, a shape of an oval flat plate, or the like.

The back housing 200 forms a housing of the display apparatus 1000. The back housing 200 is configured to protect an internal electronic component of the display apparatus 1000. A material of the back housing 200 includes but is not limited to metal, ceramic, plastic, and glass. To implement lightening and thinning of the display apparatus 1000 and ensure structural strength of the back housing 200, the metal may be selected as the material of the back housing 200.

Referring to FIG. 1 and FIG. 2, FIG. 2 is a sectional view of the display apparatus 1000 shown in FIG. 1 at a line A-A. The back housing 200 includes a back cover 201 and a frame 202. The back cover 201 is in a shape of a plate. For example, the back cover 201 is in a shape of a rectangular plate. The frame 202 is fastened to the back cover 201, and the frame 202 is disposed around an edge of the back cover 201 for one circle. For example, the frame 202 may be fixedly connected to the back cover 201 through an adhesive. The frame 202 may alternatively be integrally formed with the back cover 201, that is, the frame 202 and the back cover 201 are of an integral structure.

It may be understood that, in another embodiment, the back cover 201 may alternatively be a 3D back cover 201 or a 2.5D back cover 201.

In some embodiments, referring to FIG. 2, the display apparatus 1000 further includes a middle plate 300. The middle plate 300 is fastened to a circumference of an inner surface of the frame 202. For example, the middle plate 300 may be fastened to the frame 202 through welding, or the middle plate 300 may be integrally formed with the frame 202. The middle plate 300 serves as a structural "skeleton" of the display apparatus 1000, and components such as the display module 100, the circuit board 400, and the battery 500 may be fastened to the middle plate 300 through bonding, a threaded connection, clamping, welding, or the like.

When the display apparatus 1000 does not include the middle plate 300, the display module 100 may be fastened to the frame 202 through bonding or the like. Components such as the circuit board 400 and the battery 500 may be fastened to an inner surface of the back cover 201 through a threaded connection, clamping, welding, or the like; or may be fastened, through a threaded connection, clamping, welding, or the like, to a surface that is of the display module 100 and that faces the back cover 201.

Referring to FIG. 1, the circuit board 400 includes a primary circuit board 401 and a secondary circuit board 402. The secondary circuit board 402 and the primary circuit board 401 may be electrically connected through a connection structure (not shown in FIG. 1), to implement data and signal transmission between the secondary circuit board 402 and the primary circuit board 401. The connection structure may be a flexible printed circuit board (flexible printed circuit, FPC). In another embodiment, the connection structure may alternatively be a conducting wire or an enamelled wire.

The primary circuit board 401 is configured to integrate a control chip. The control chip may be, for example, an application processor (application processor, AP), a double data rate (double data rate, DDR) synchronous dynamic random access memory, and a universal flash storage (universal flash storage, UFS). In some embodiments, the primary circuit board 401 is electrically connected to the display module 100, and the primary circuit board 401 is configured to control the display screen 102 to display an image or a video.

The primary circuit board 401 may be a rigid circuit board, a flexible circuit board, or a rigid-flexible circuit board. The primary circuit board 401 may be an FR-4 dielectric board, a Rogers (Rogers) dielectric board, an FR-4+Rogers mixed dielectric board, or the like. Herein, FR-4 is a code name of a level of a flame-resistant material, and the Rogers dielectric board is a highfrequency board.

The secondary circuit board 402 is configured to integrate electronic elements such as a radio frequency front end of an antenna (such as a 5G antenna) and a universal serial bus (universal serial bus, USB) device.

The secondary circuit board 402 may be a rigid circuit board, a flexible circuit board, or a rigid-flexible circuit board. The secondary circuit board 402 may be an FR-4 dielectric board, a Rogers (Rogers) dielectric board, an FR-4+Rogers mixed dielectric board, or the like.

Still referring to FIG. 1, the battery 500 is located between the primary circuit board 401 and the secondary circuit board 402. The battery 500 is configured to supply power to electronic devices in the display apparatus 1000, such as the display module 100, the primary circuit board 401, and the secondary circuit board 402. In some embodiments, a mounting groove of the battery 500 is provided on a surface that is of the middle plate 300 and that faces the back cover 201, and the battery 500 is mounted in the mounting groove of the battery 500.

The display module 100 is configured to display an image, a video, and the like. Referring to FIG. 2, the display module 100 may include a light-transmissive cover plate 101 and the display screen 102. The light-transmissive cover plate 101 and the display screen 102 are stacked and fixedly connected. The light-transmissive cover plate 101 is mainly configured to protect the display screen 102 and prevent dust. A material of the light-transmissive cover plate 101 includes but is not limited to glass, acrylic, and the like. The light-transmissive cover plate 101 in this embodiment is a 3D cover plate, so that the display apparatus 1000 can have a more beautiful appearance. In another embodiment, the light-transmissive cover plate 101 may alternatively be a 2D cover plate or a 2.5D cover plate.

Still referring to FIG. 2, the light-transmissive cover plate 101 is disposed opposite to the back cover 201, and the light-transmissive cover plate 101 may be fastened to the middle plate 300. For example, a sinking station 301 is disposed on a surface on a side that is of the middle plate 300 and that faces the light-transmissive cover plate 101, and the light-transmissive cover plate 101 is fixedly connected to the sinking station 301. In some embodiments, the light-transmissive cover plate 101 may be fastened to the middle plate 300 through an adhesive. Specifically, the light-transmissive cover plate 101 may be fastened to the sinking station 301 through a caulking adhesive 103. The light-transmissive cover plate 101, the back cover 201, and the frame 202 enclose internal accommodating space of the display apparatus 1000. The internal accommodating space accommodates the display screen 102, the primary circuit board 401, the secondary circuit board 402, and the battery 500.

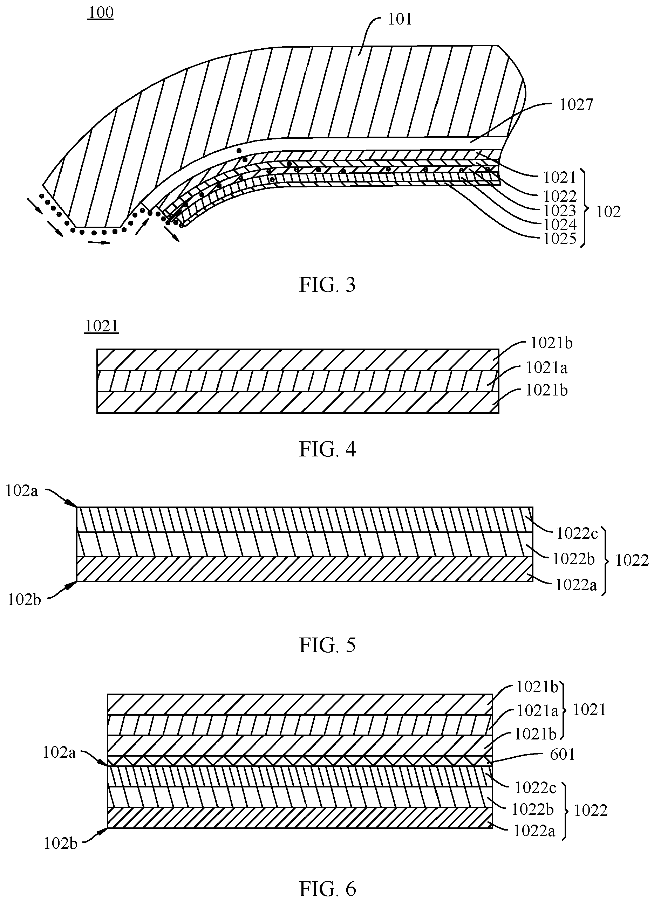

Referring to FIG. 3, FIG. 3 is a partial sectional view of the display module 100 according to some embodiments of this application. The display screen 102 includes a polarizer 1021, a display panel 1022, a back plane film 1023, a buffer foam 1024, and an electrostatic discharge layer 1025.

Specifically, the polarizer 1021 (polarizer, POL) is also referred to as a polarizer, and is configured to control a polarization direction of a beam. To be specific, when natural light passes through the polarizer 1021, light whose polarization direction is perpendicular to a transmission axis of the polarizer 1021 is absorbed, and only polarized light whose polarization direction is parallel to the transmission axis of the polarizer 1021 remains in transmitted light.

In some embodiments, referring to FIG. 4, FIG. 4 is a partial sectional view of the polarizer 1021 in the display module 100 shown in FIG. 3. The polarizer 1021 is formed by a plurality of layers of films through lamination. Specifically, the polarizer 1021 includes a polyvinyl alcohol (polyvinyl alcohol, PVA) film 1021a and a tricellulose acetate (tricellulose acetate, TCA) film 1021b disposed on each of two sides of the polyvinyl alcohol film 1021a. The tricellulose acetate film 1021b may be coated on surfaces on the two sides of the polyvinyl alcohol film 1021a. The polyvinyl alcohol film 1021a absorbs polarized light and is penetrated by the polarized light. The tricellulose acetate film 1021b is used to protect the polyvinyl alcohol film 1021a to isolate the polyvinyl alcohol film 1021a from moisture and air, to prevent the polyvinyl alcohol film 1021a from losing polarization performance due to water absorption and fading.

The polarizer 1021 is bonded, through a transparent optically clear adhesive (optically clear adhesive, OCA) 1027, to a surface on a side that is of the light-transmissive cover plate 101 and that faces the back cover 201.

The display panel 1022 may be a flexible display panel, or may be a rigid display panel. For example, the display panel 1022 may be an organic light-emitting diode (organic light-emitting diode, OLED) display panel, an active-matrix organic light-emitting diode or an active-matrix organic light-emitting diode (active-matrix organic light-emitting diode, AMOLED) display panel, a mini light-emitting diode (mini organic light-emitting diode) display panel, a micro light-emitting diode (micro organic light-emitting diode) display panel, a micro organic light-emitting diode (micro organic light-emitting diode) display panel, a quantum dot light emitting diode (quantum dot light emitting diodes, QLED) display panel, or a liquid crystal display panel (liquid crystal display, LCD).

Referring to FIG. 5, FIG. 5 is a partial sectional view of the display panel 1022 in the display module 100 shown in FIG. 3. The display panel 1022 includes an underlay substrate 1022a, a thin film transistor device layer 1022b located on one side of the underlay substrate 1022a, and a light-emitting unit 1022c located on a side that is of the thin film transistor device layer 1022b and that is away from the underlay substrate 1022a. A thin film transistor is disposed at the thin film transistor device layer 1022b.

Still referring to FIG. 5, the display panel 1022 has a display side 102a and a non-display side 102b disposed opposite to each other. The display side 102a of the display panel 1022 faces the light-transmissive cover plate 101. The non-display side 102b of the display panel 1022 faces the back cover 201. Specifically, a side on which the underlay substrate 1022a is located is the non-display side 102b, and a side on which the light-emitting unit 1022c is located is the display side 102a.

Referring to FIG. 6, FIG. 6 is a schematic diagram of assembly of the display panel 1022 shown in FIG. 5 and the polarizer 1021 shown in FIG. 4. The display panel 1022 is fixedly connected to the polarizer 1021 by using a first bonding layer 601. The first bonding layer 601 may be a pressure sensitive adhesive (pressure sensitive adhesive, PSA) layer, and a pressure sensitive adhesive has low light leakage and is reusable. More specifically, the first bonding layer 601 may be a grid adhesive layer. The first bonding layer 601 may be integrated on the polarizer 1021, that is, the first bonding layer 601 and the polarizer 1021 are in an integral structure. During assembly, the display panel 1022 may be bonded to the first bonding layer 601, so that the display panel 1022 and the polarizer 1021 may be fastened.

The back plane film 1023 (back plane film, BPF) is located on the non-display side 102b of the display panel 1022. The back plane film 1023 may be configured to support the display panel 1022. The back plane film 1023 may be a polyethylene terephthalate (polyethylene terephthalate, PET) layer.

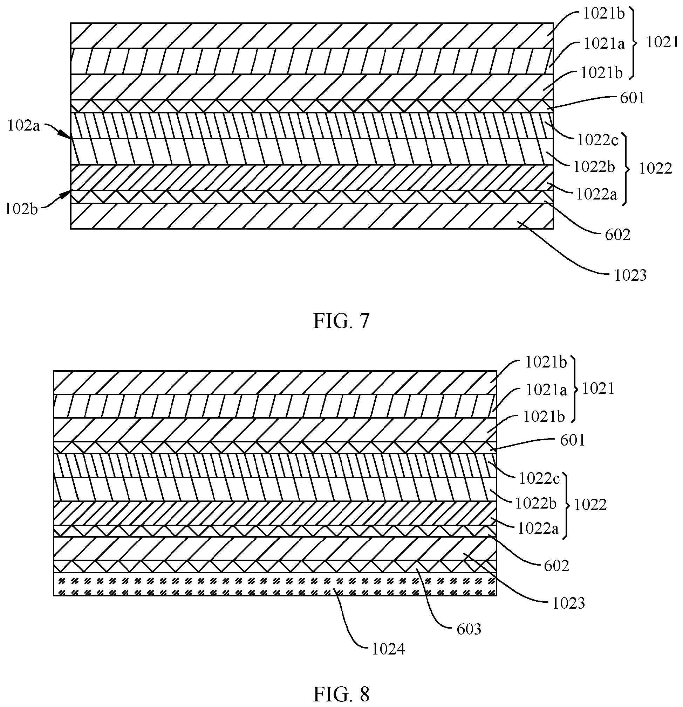

Referring to FIG. 7, FIG. 7 is a schematic diagram of assembly of the back plane film 1023, the display panel 1022, and the polarizer 1021 in the display module 100 shown in FIG. 3. The back plane film 1023 and the display panel 1022 are connected through bonding by using a second bonding layer 602. Optionally, the second bonding layer 602 is a pressure sensitive adhesive layer. Further, the second bonding layer 602 is a grid adhesive layer. The second bonding layer 602 may be integrated on the back plane film 1023, that is, the second bonding layer 602 and the back plane film 1023 are in an integral structure. During assembly, the back plane film 1023 may be fastened on the non-display side 102b of the display panel 1022 through bonding by using the second bonding layer 602.

The buffer foam 1024 is configured to provide a buffering and shock resistance effect, to improve an impact resistance capability of the display module 100. Referring to FIG. 8, FIG. 8 is a schematic diagram of assembly of the buffer foam 1024, the back plane film 1023, the display panel 1022, and the polarizer 1021 in the display module 100 shown in FIG. 3. The buffer foam 1024 is disposed on a surface on a side that is of the back plane film 1023 and that is away from the display panel 1022. Specifically, the buffer foam 1024 may be bonded to the back plane film 1023 by using a third bonding layer 603. The third bonding layer 603 may be a pressure sensitive adhesive layer. Further, the third bonding layer 603 is a grid adhesive layer. The third bonding layer 603 may be disposed on the back plane film 1023, or may be disposed on the buffer foam 1024.

The electrostatic discharge layer 1025 is configured to conduct static electricity. The electrostatic discharge layer 1025 is disposed on a surface on a side that is of the buffer foam 1024 and that is away from the back plane film 1023.

The electrostatic discharge layer 1025 is suitable for grounding. Specifically, a grounding point is disposed on the display apparatus 1000, and the electrostatic discharge layer 1025 is electrically connected to the grounding point. In some embodiments, the grounding point may be disposed on the middle plate 300 of the display apparatus 1000, or may be disposed on the circuit board 400 of the display apparatus 1000. In this way, electrostatic charges can be discharged by using the electrostatic discharge layer 1025, to prevent the electrostatic charges from interfering with an electric field of the display panel 1022.

In some embodiments, the buffer foam 1024 is integrated with the electrostatic discharge layer 1025. The buffer foam 1024 and the electrostatic discharge layer 1025 may form a super composite film (super composite film, SCF). When the third bonding layer 603 is integrated on the buffer foam 1024, during assembly, the buffer foam 1024 and the electrostatic discharge layer 1025 (that is, the super composite film) may be bonded as a whole, by using the third bonding layer 603, to the surface on the side that is of the back plane film 1023 and that is away from the display panel 1022.

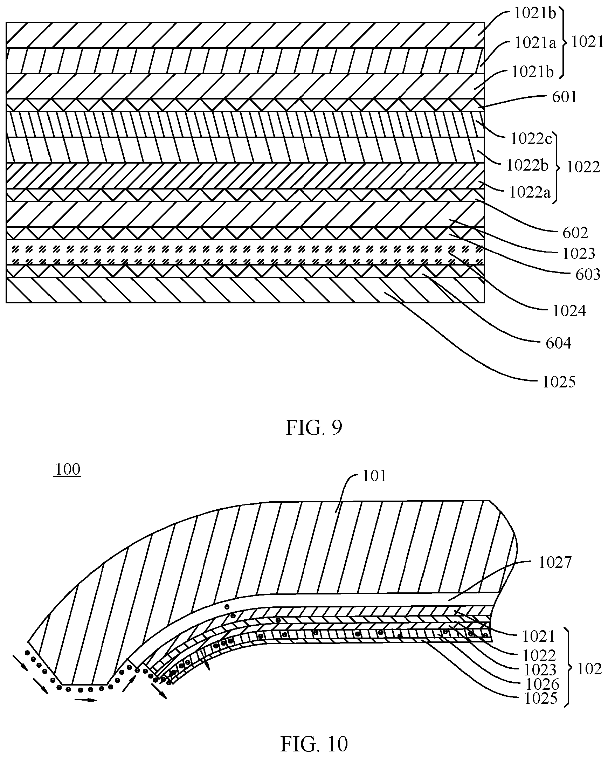

Referring to FIG. 9, FIG. 9 is a schematic diagram of assembly of the electrostatic discharge layer 1025, the buffer foam 1024, the back plane film 1023, the display panel 1022, and the polarizer 1021 in the display module 100 shown in FIG. 3. The electrostatic discharge layer 1025 may be fixedly connected, by using a fourth bonding layer 604, to the surface on the side that is of the buffer foam 1024 and that is away from the back plane film 1023. The fourth bonding layer 604 may be a pressure sensitive adhesive. Further, the fourth bonding layer 604 is a grid adhesive.

In some embodiments, the electrostatic discharge layer 1025 may be a metal layer. For example, the electrostatic discharge layer 1025 is a copper foil layer. In this way, the electrostatic discharge layer 1025 not only can discharge static electricity, but also can provide a heat dissipation effect, thereby improving a heat dissipation capability of the display module 100. In some other embodiments, the electrostatic discharge layer 1025 may alternatively be another conductive material such as graphene, provided that the electrostatic discharge layer 1025 can conduct electricity.

For example, a thickness of the electrostatic discharge layer 1025 is 0.025 mm, 0.03 mm, 0.04 mm, 0.05 mm, or the like. In this way, it is advantageous to reduce an overall thickness of the display module 100 on the basis of ensuring a conductive effect of the electrostatic discharge layer 1025.

When a user uses the display apparatus 1000, a large quantity of electrostatic charges are generated if a finger of the user rubs against a surface of the light-transmissive cover plate 101. Referring back to FIG. 2 and with reference to FIG. 3, the electrostatic charges are conducted along the caulking adhesive 103 at an edge of the display module 100 to a side surface of the display module 100. When the electrostatic charges are transmitted to the electrostatic discharge layer 1025, the electrostatic charges can be discharged by using the electrostatic discharge layer 1025.

However, because an impedance range of the transparent optically clear adhesive 1027 is 10¹² Ω~10¹³ Ω, an impedance range of the polarizer 1021 is 10¹⁰ Ω~10¹¹ Q, an impedance range of the back plane film 1023 is 10⁴ Ω~10⁷ Q, an impedance range of the buffer foam 1024 is 10¹¹ Ω~10¹² Ω, and an impedance of the pressure sensitive adhesive is up to 10¹³ Q, the electrostatic charges entering the side surface of the display module 100 cannot be smoothly conducted to the electrostatic discharge layer 1025, but enter the back plane film 1023 with a relatively low impedance for accumulation. The electrostatic charges continuously accumulate and intensify, an offset of a channel characteristic on the display side 102a of the display panel 1022 is caused through sensing, and a phenomenon of greening of the display module 100 occurs.

To resolve the technical problem of greening of the display module 100, referring to FIG. 10, FIG. 10 is a partial sectional view of the display module 100 according to some other embodiments of this application. The display module 100 in this embodiment includes a light-transmissive cover plate 101, a polarizer 1021, a display panel 1022, a back plane film 1023, a buffer layer 1026, and an electrostatic discharge layer 1025. It may be understood that, in another embodiment, the display module 100 may not include the light-transmissive cover plate 101 and the polarizer 1021.

In this embodiment, structures of the light-transmissive cover plate 101, the polarizer 1021, the display panel 1022, the back plane film 1023, and the electrostatic discharge layer 1025 may be the same as the structures structure of the light-transmissive cover plate 101, the polarizer 1021, the display panel 1022, the back plane film 1023, and the electrostatic discharge layer 1025 in the embodiment shown in FIG. 3. One of differences between the display module 100 in this embodiment and the display module 100 in the embodiment shown in FIG. 3 lies in that in this embodiment, an impedance of the buffer layer 1026 is less than an impedance of the back plane film 1023, and at least a part of a surface of the buffer layer 1026 is in direct contact with the electrostatic discharge layer 1025.

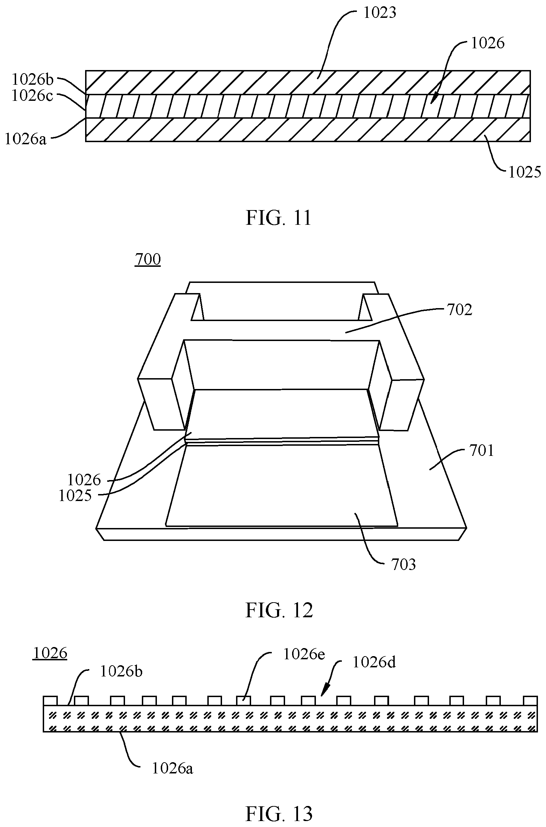

In some embodiments, referring to FIG. 11, FIG. 11 is a schematic diagram of assembly of the back plane film 1023, the buffer layer 1026, and the electrostatic discharge layer 1025 in the display module 100 shown in FIG. 10. The buffer layer 1026 has a first surface 1026a and a second surface 1026b disposed opposite to each other in a thickness direction of the buffer layer 1026. The first surface 1026a is fixedly connected to the electrostatic discharge layer 1025, and the second surface 1026b is fixedly connected to the back plane film 1023. An entire surface of the first surface 1026a is in direct contact with the electrostatic discharge layer 1025; or one part of the surface of the first surface 1026a is in direct contact with the electrostatic discharge layer 1025, and the other part of the surface of the first surface 1026a is not in direct contact with the electrostatic discharge layer 1025.

Still referring to FIG. 11, the buffer layer 1026 further includes a first side wall surface 1026c located between the first surface 1026a and the second surface 1026b. In another embodiment, a part of the first side wall surface 1026c may be in direct contact with the electrostatic discharge layer 1025, provided that at least a part of the surface of the buffer layer 1026 is in direct contact with the electrostatic discharge layer 1025. In this way, an electrostatic discharge path can be formed between the buffer layer 1026 and the electrostatic discharge layer 1025, and electrostatic charges on the buffer layer 1026 can be transmitted to the electrostatic discharge layer 1025 by using a contact surface between the buffer layer 1026 and the electrostatic discharge layer 1025, and therefore the electrostatic charges are discharged by using the electrostatic discharge layer 1025.

The electrostatic charges easily accumulate at a film layer with a low impedance in the display module 100. In this embodiment, the impedance of the buffer layer 1026 is lower than the impedance of the back plane film 1023, that is, the impedance of the buffer layer 1026 is lower than an impedance of another film layer in the display module 100. In this way, the electrostatic charges entering the side surface of the display module 100 enter the buffer layer 1026 easily. Because at least a part of the surface of the buffer layer 1026 is in direct contact with the electrostatic discharge layer 1025, an electrostatic discharge path can be formed between the buffer layer 1026 and the electrostatic discharge layer 1025, so that the electrostatic charges in the buffer layer 1026 can be smoothly transmitted to the electrostatic discharge layer 1025 through a contact surface on which the buffer layer 1026 is in direct contact with the electrostatic discharge layer 1025, and are discharged by using the electrostatic discharge layer 1025.

In the display module 100 in this embodiment of this application, the electrostatic charges on the side surface of the display module 100 can be smoothly transmitted to the grounded electrostatic discharge layer 1025, to avoid accumulation of the electrostatic charges in the film layer of the display module 100, thereby preventing the electrostatic charges from interfering with a drive circuit of the display module 100, and resolving a problem of greening of the display module 100.

Compared with a technical solution in a related technology in which conductive liquid is coated at an edge of a film material of the display screen 102 in the display module 100 to connect the electrostatic discharge layer 1025 and the light-transmissive cover plate 101 by using the conductive liquid to form an electrostatic discharge path, in the display module 100 in this embodiment of this application, a process of coating the conductive liquid does not need to be added additionally, and processing efficiency is high, which helps reduce costs.

In some embodiments, at least a part of the surface of the buffer layer 1026 is in direct contact with the back plane film 1023. Specifically, at least a part of the second surface 1026b of the buffer layer 1026 is in direct contact with the back plane film 1023, or at least a part of the first side wall surface 1026c of the buffer layer 1026 is in direct contact with the back plane film 1023. In this way, an electrostatic discharge path can be formed between the back plane film 1023, the buffer layer 1026, and the electrostatic discharge layer 1025, so that electrostatic charges accumulated on the back plane film 1023 can be transmitted to the electrostatic discharge layer 1025 by using the buffer layer 1026 and are discharged.

In some embodiments, the buffer layer 1026 is conductive silica gel. The conductive silica gel means distributing conductive particles such as silver-coated copper powder, nickel-coated graphite powder, organic chelation, and metal chelation in silica gel (also referred to as silica gel), and being conducted through mutual contact between the conductive particles to achieve good conductive performance. In other words, the buffer layer 1026 in this embodiment includes silica gel and conductive particles, and the conductive particles are distributed in the silica gel. Optionally, the conductive particles are evenly distributed in the silica gel.

It may be understood that, an impedance of the conductive silica gel may be adjusted to a proper range by adjusting a quantity of added conductive particles and a specific substance. In addition, the conductive silica gel has elasticity and can provide a buffering and shock resistance effect, to improve an impact resistance capability of the display module 100. In this way, the conductive silica gel is used as the buffer layer 1026, so that not only an electrostatic grounding path can be formed between the buffer layer 1026 and the electrostatic discharge layer 1025 through contact between the buffer layer 1026 and the electrostatic discharge layer 1025, but also the display module 100 can be effectively protected. A structure is simple and a design is ingenious.

In addition, the conductive silica gel has viscosity, and during assembly, the conductive silica gel can be directly bonded to a surface of the electrostatic discharge layer 1025 and a surface of the back plane film 1023. Specifically, referring to FIG. 11, the second surface 1026b of the conductive silica gel is in direct contact with and bonded to a surface on a side that is of the back plane film 1023 and that is away from the display panel 1022, and the first surface 1026a of the conductive silica gel is in direct contact with and fastened to a surface on a side that is of the electrostatic discharge layer 1025 and that faces the display panel 1022. In this way, in one aspect, a fixed connection between the conductive silica gel and the back plane film 1023 and a fixed connection between the conductive silica gel and the electrostatic discharge layer 1025 may be implemented through viscosity of the conductive silica gel, so that a pressure sensitive adhesive used to bond the conductive silica gel and the electrostatic discharge layer 1025 and a pressure sensitive adhesive used to bond the conductive silica gel and the back plane film 1023 are omitted, thereby helping reduce an overall thickness of the display module 100. In another aspect, the surface on the side that is of the back plane film 1023 and that is away from the display panel 1022 is in direct contact with the second surface 1026b of the buffer layer 1026, and the surface on the side that is of the electrostatic discharge layer 1025 and that faces display panel 1022 is in direct contact with the first surface 1026a of the buffer layer 1026, so that an electrostatic grounding path can be formed between the back plane film 1023, the buffer layer 1026, and the electrostatic discharge layer 1025, and electrostatic charges accumulated on the back plane film 1023 and the buffer layer 1026 can be smoothly transmitted to the electrostatic discharge layer 1025 and are discharged.

Specifically, an orthographic projection of the first surface 1026a of the buffer layer 1026 on a plane in which the electrostatic discharge layer 1025 is located is a first projection, the first projection and the electrostatic discharge layer 1025 have a first overlapping region, and a part that is of the first surface 1026a and that corresponds to the first overlapping region is in direct contact with the electrostatic discharge layer 1025. In other words, a part that is of the first surface 1026a and that can form the first overlapping region is in direct contact with the electrostatic discharge layer 1025. In this way, a contact area between the buffer layer 1026 and the electrostatic discharge layer 1025 can be increased, so that in one aspect, electrostatic discharge efficiency can be improved, and in another aspect, reliability of connection between the buffer layer 1026 and the electrostatic discharge layer 1025 can be improved.

For example, when an outer contour of the first projection is located on an inner side of an outer edge of the electrostatic discharge layer 1025, the entire surface of the first surface 1026a is in direct contact with the electrostatic discharge layer 1025; when the outer contour of the first projection coincides with the outer edge of the electrostatic discharge layer 1025, the entire surface of the first surface 1026a is in direct contact with the electrostatic discharge layer 1025; and when the outer contour of the first projection is located on an outer side of the outer edge of the electrostatic discharge layer 1025, a part of the surface of the first surface 1026a is in direct contact with the electrostatic discharge layer 1025.

In some embodiments, an orthographic projection of the second surface 1026b of the buffer layer 1026 on a plane in which the back plane film 1023 is located is a second projection, the second projection and the back plane film 1023 have a second overlapping region, and a part that is of the second surface 1026b and that corresponds to the second overlapping region is in direct contact with the back plane film 1023. In other words, a part that is of the second surface 1026b and that can form the second overlapping region is in direct contact with the back plane film 1023. In this way, a contact area between the buffer layer 1026 and the back plane film 1023 can be increased, so that in one aspect, electrostatic discharge efficiency can be improved, and in another aspect, reliability of connection between the buffer layer 1026 and the back plane film 1023 can be improved.

For example, when an outer contour of the second projection is located on an inner side of an outer edge of the back plane film 1023, an entire surface of the second surface 1026b is in direct contact with the back plane film 1023; when the outer contour of the second projection coincides with the outer edge of the back plane film 1023, the entire surface of the second surface 1026b is in direct contact with the electrostatic discharge layer 1025; and when the outer contour of the second projection is located on an outer side of the outer edge of the back plane film 1023, a part of the surface of the second surface 1026b is in direct contact with the electrostatic discharge layer 1025.

In some embodiments, during processing, liquid conductive silica gel may be directly coated on the electrostatic discharge layer 1025, and then the conductive silica gel is solidified on the surface of the electrostatic discharge layer 1025 through solidification by heating. Optionally, the conductive silica gel may be coated on the surface of the electrostatic discharge layer 1025 through scrape coating or spin coating. In this way, a thickness of the conductive silica gel can be adjusted, and uniformity of the conductive silica gel coated on the back plane film 1023 and the electrostatic discharge layer 1025 can be improved.

It may be understood that, a larger thickness of the conductive silica gel indicates a better buffering effect. However, an excessively large thickness of the conductive silica gel increases a thickness of the display module 100, which is not conducive to implementing a lightening and thinning design of the display apparatus 1000. To take into account the buffering effect of the conductive silica gel and lightening and thinning of the display apparatus 1000, the thickness of the conductive silica gel in this embodiment of this application is greater than or equal to 0.05 mm and less than or equal to 0.15 mm. For example, the thickness of the conductive silica gel is 0.05 mm, 0.06 mm, 0.07 mm, 0.08 mm, 0.09 mm, 0.1 mm, 0.11 mm, 0.12 mm, 0.13 mm, 0.14 mm, or 0.15 mm.

Further, the thickness of the conductive silica gel may be greater than or equal to 0.08 mm and less than or equal to 0.12 mm.

In this embodiment, a gain of 0.055 mm~0.155 mm may be obtained in terms of thickness reduction of the display module 100.

For example, when in the embodiment shown in FIG. 3, a thickness of the buffer foam 1024 of the display module 100 is 0.15 mm, a thickness of the third bonding layer 603 used to bond the buffer foam 1024 and the back plane film 1023 is 0.04 mm, and a thickness of the fourth bonding layer 604 used to bond the buffer foam 1024 and the electrostatic discharge layer 1025 is 0.015 mm, because in the display module 100 in this embodiment, a bonding layer does not need to be disposed between the back plane film 1023 and the buffer layer 1026, and a bonding layer does not need to be disposed between the buffer layer 1026 and the electrostatic discharge layer 1025, so that when the thickness of the conductive silica gel in this embodiment is 0.1 mm, a total thickness of the display module 100 in this embodiment can be reduced by 0.105 mm compared with a total thickness of the display module 100 in the embodiment shown in FIG. 4.

In some embodiments, the conductive silica gel (that is, the buffer layer 1026) on the electrostatic discharge layer 1025 may be scrape coated by using a scraper-type coating machine 700 to adjust the thickness of the conductive silica gel. Referring to FIG. 12, FIG. 12 is a schematic diagram of scrape coating the conductive silica gel on the electrostatic discharge layer 1025 by using the scraper-type coating machine 700. The scraper-type coating machine 700 may implement scrape coating of a coating layer with a thickness of 0.05 mm~0.5 mm.

The scraper-type coating machine 700 includes a workbench 701 and a scraper 702. The scraper 702 is disposed on the workbench 701, and the scraper 702 may reciprocate relative to the workbench 701 in a horizontal direction. During coating, the liquid conductive silica gel may be first coated on a surface that is of the electrostatic discharge layer 1025 and that is away from the workbench 701, and then the conductive silica gel coated on the electrostatic discharge layer 1025 is adaptively scraped by using a spacing between the scraper 702 and the electrostatic discharge layer 1025.

Further, a heating apparatus 703 is further disposed on the workbench 701, and the heating apparatus 703 is configured to heat the thermally conductive silica gel to solidify the thermally conductive silica gel. For example, the heating apparatus 703 is a heating plate, and the electrostatic discharge layer 1025 may be fastened to the heating plate. In this way, in the process of scrape coating the conductive silica gel by using the scraper 702, the conductive silica gel may be heated synchronously, thereby improving processing efficiency.

After the conductive silica gel is coated on the electrostatic discharge layer 1025, the conductive silica gel and the electrostatic discharge layer 1025 may be attached to the back plane film 1023 as a whole through viscosity of the conductive silica gel. Based on this, to prevent bubbles from occurring between the conductive silica gel and the back plane film 1023 in a bonding process, a concave-convex structure 1026d may be disposed on a surface on a side that is of the conductive silica gel and that is away from the electrostatic discharge layer 1025. In this way, bubbles can be prevented from being generated in a process of bonding the conductive silica gel and the back plane film 1023, thereby preventing defects such as bulges from occurring on the back plane film 1023.

In some embodiments, referring to FIG. 13, FIG. 13 is a schematic diagram of a partial structure of the buffer layer 1026 according to some embodiments of this application. A convex part 1026e protruding from the second surface 1026b is disposed on the second surface 1026b of the buffer layer 1026 (that is, the conductive silica gel), so that the concave-convex structure 1026d can be formed on the second surface 1026b. The convex part 1026e may be in a dot shape, may be in a strip shape, or may be in a grid shape.

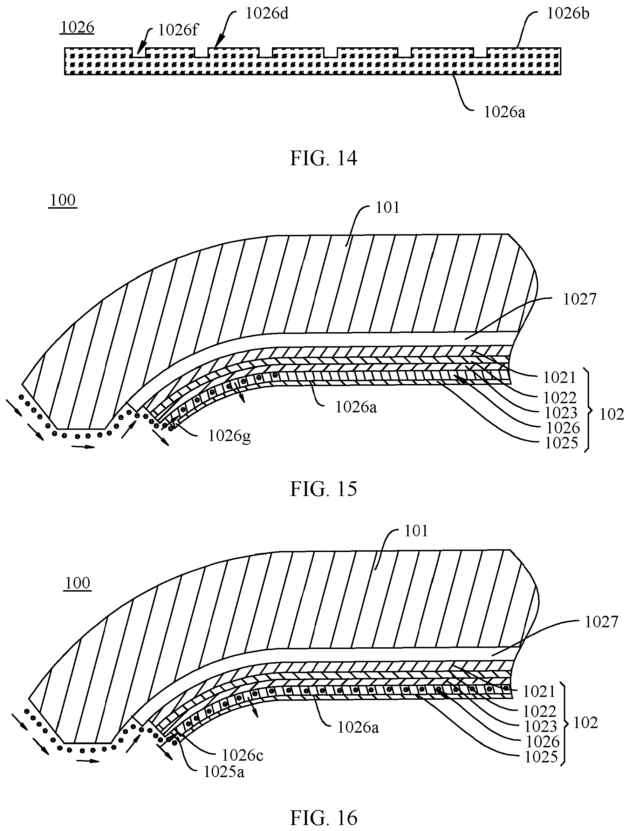

In some other embodiments, referring to FIG. 14, FIG. 14 is a schematic diagram of a partial structure of the buffer layer 1026 according to some other embodiments of this application. A groove part 1026f recessed toward the first surface 1026a is disposed on the second surface 1026b of the buffer layer 1026 (that is, the conductive silica gel), so that the concave-convex structure 1026d can also be formed on the second surface 1026b. The groove part 1026f may be in a dot shape, may be in a strip shape, or may be in a grid shape.

Further, after the conductive silica gel is formed on the electrostatic discharge layer 1025, a release film may be attached to the surface on the side that is of the conductive silica gel and that is away from the electrostatic discharge layer 1025, that is, the release film may be attached to the second surface 1026b of the conductive silica gel. When the conductive silica gel needs to be connected to the back plane film 1023 through bonding, the release film may be removed. In this way, the conductive silica gel can be protected during transfer and transportation of a composite film layer, to prevent the conductive silica gel from being scratched or lost during transfer and transportation.

Based on any of the foregoing embodiments, the impedance of the buffer layer 1026 is greater than an impedance of the electrostatic discharge layer 1025. For example, an impedance range of the buffer layer 1026 is 10³ Ω~10⁶ Ω. In this way, a conductive gradient can be formed between the buffer layer 1026 and the electrostatic discharge layer 1025, so that an electrostatic dissipation gradient can be formed between the buffer layer 1026 and the electrostatic discharge layer 1025, thereby helping improve electrostatic dissipation efficiency and avoid greening of the display module 100. In addition, the impedance of the buffer layer 1026 is set to be greater than the impedance of the electrostatic discharge layer 1025 to ensure that an electrostatic charge dissipation layer, that is, the electrostatic discharge layer 1025, that plays a main role is away from the display panel 1022, so as to prevent an electrostatic dissipation process from causing a disturbance or another impact on a drive circuit in the display panel 1022, thereby helping further improve performance of the display module 100.

In some other embodiments, referring to FIG. 15, FIG. 15 is a partial sectional view of the display module 100 according to some other embodiments of this application. A difference between the display module 100 in this embodiment and the display module 100 in the embodiment shown in FIG. 10 lies in that a first flanged part 1026g folded toward the electrostatic discharge layer 1025 is disposed at an outer edge of the buffer layer 1026. The first flanged part 1026g may be disposed around the outer edge of the buffer layer 1026 for one circle. Alternatively, the first flanged part 1026g is formed into a plate-like structure. When the first flanged part 1026g is formed into a plate-like structure, there may be one first flanged part 1026g or a plurality of first flanged parts 1026g spaced apart in a circumferential direction of the buffer layer 1026. In this embodiment, an inner surface of the first flanged part 1026g may be in contact with a side wall surface of the electrostatic discharge layer 1025, that is, the first flanged part 1026g wraps the side wall surface of the electrostatic discharge layer 1025. In this way, in addition to being in direct contact with and bonded, by using the first surface 1026a, to the surface on the side that is of the electrostatic discharge layer 1025 and that faces the buffer layer 1026, the buffer layer 1026 can be further in direct contact with and bonded to the side wall surface of the electrostatic discharge layer 1025 by using the inner surface of the first flanged part 1026g. Therefore, a contact area between the buffer layer 1026 and the electrostatic discharge layer 1025 can be increased, and reliability of connection between the buffer layer 1026 and the electrostatic discharge layer 1025 can be improved, thereby preventing the electrostatic discharge layer 1025 from falling off from the buffer layer 1026.

Based on this, when the buffer layer 1026 is not conductive silica gel, but is another substance having no viscosity, the first surface 1026a of the buffer layer 1026 may be bonded, by using a bonding layer, to the surface on the side that is of the electrostatic discharge layer 1025 and that faces the buffer layer 1026, and may be in direct contact with the electrostatic discharge layer 1025 by using the first flanged part 1026g. In this way, an electrostatic discharge path can also be formed between the buffer layer 1026 and the electrostatic discharge layer 1025, so that electrostatic charges at the buffer layer 1026 can be smoothly transmitted to the electrostatic discharge layer 1025 and are discharged by using the electrostatic discharge layer 1025.

In still some other embodiments, referring to FIG. 16, FIG. 16 is a partial sectional view of the display module 100 according to still some other embodiments of this application. A difference between the display module 100 in this embodiment and the display module 100 in the embodiment shown in FIG. 10 lies in that in this embodiment, a second flanged part 1025a folded toward the buffer layer 1026 is disposed at an outer edge of the electrostatic discharge layer 1025. The second flanged part 1025a may be disposed around the outer edge of the electrostatic discharge layer 1025 for one circle. Alternatively, the second flanged part 1025a is formed into a plate-like structure. When the second flanged part 1025a is formed into a plate-like structure, there may be one second flanged part 1025a or a plurality of second flanged parts 1025a spaced apart in a circumferential direction of the electrostatic discharge layer 1025. In this embodiment, an inner surface of the second flanged part 1025a may be in contact with the first side wall surface 1026c of the buffer layer 1026, that is, the first flanged part 1026g wraps the first side wall surface 1026c of the buffer layer 1026. In this way, in addition to being in direct contact with and bonded, by using the first surface 1026a, to the surface on the side that is of the electrostatic discharge layer 1025 and that faces the buffer layer 1026, the buffer layer 1026 can be further in direct contact with and bonded to the first side wall surface 1026c of the buffer layer 1026 by using the inner surface of the second flanged part 1025a. Therefore, a contact area between the buffer layer 1026 and the electrostatic discharge layer 1025 can be increased, and reliability of connection between the buffer layer 1026 and the electrostatic discharge layer 1025 can be improved, thereby preventing the electrostatic discharge layer 1025 from falling off from the buffer layer 1026.

Similarly, based on this, when the buffer layer 1026 is not conductive silica gel, but is another substance having no viscosity, for example, when the buffer layer 1026 is conductive rubber, the first surface 1026a of the buffer layer 1026 may be bonded, by using a bonding layer, to the surface on the side that is of the electrostatic discharge layer 1025 and that faces the buffer layer 1026, and may be in direct contact with the inner surface of second flanged part 1025a by using the second side wall surface of the buffer layer 1026. In this way, an electrostatic discharge path can also be formed between the buffer layer 1026 and the electrostatic discharge layer 1025, so that electrostatic charges at the buffer layer 1026 can be smoothly transmitted to the electrostatic discharge layer 1025 and are discharged by using the electrostatic discharge layer 1025.

Based on any of the foregoing embodiments, when the buffer layer 1026 is a conductive member, the buffer layer 1026 may also be electrically connected to the electrostatic discharge layer 1025. In this embodiment, the buffer layer 1026 may be in direct contact with the electrostatic discharge layer 1025, or may not be in direct contact with the electrostatic discharge layer 1025. When the buffer layer 1026 is not in direct contact with the electrostatic discharge layer 1025, the buffer layer 1026 may be electrically connected to the electrostatic discharge layer 1025 by using a conductive part.

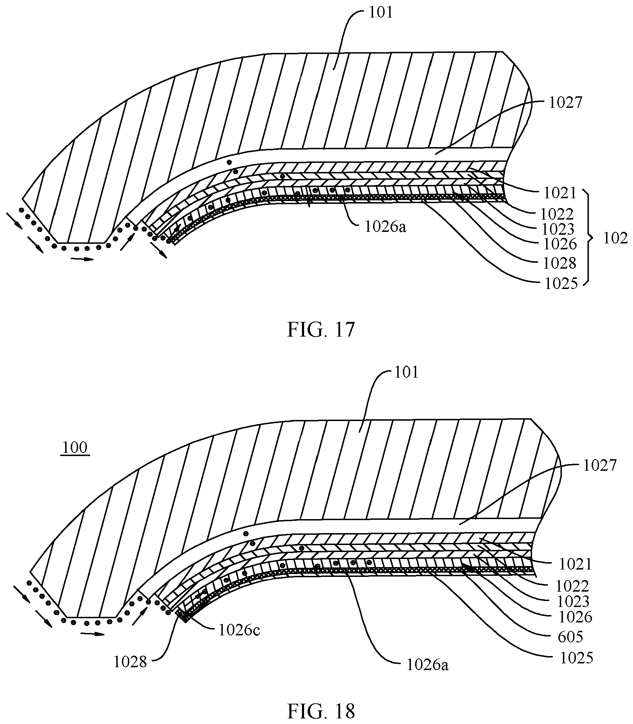

In still some other embodiments, referring to FIG. 17, FIG. 17 is a partial sectional view of the display module 100 according to still some other embodiments of this application. A difference between the display module 100 in this embodiment and the display module 100 in the embodiment shown in FIG. 10 lies in that the buffer layer 1026 in this embodiment is not in direct contact with the electrostatic discharge layer 1025 and the buffer layer 1026 is connected to the electrostatic discharge layer 1025 by using a conductive part 1028. In this embodiment, the conductive part 1028 is a conductive adhesive, and the conductive part 1028 is located between the first surface 1026a of the buffer layer 1026 and the surface on the side that is of the electrostatic discharge layer 1025 and that faces the buffer layer 1026. The first surface 1026a of the buffer layer 1026 is fixedly connected, by using the conductive adhesive, to the surface on the side that is of the electrostatic discharge layer 1025 and that faces the buffer layer 1026. In this way, an electrostatic discharge path can be formed between the buffer layer 1026, the conductive part 1028, and the electrostatic discharge layer 1025, thereby discharging electrostatic charges conveniently.

In still some other embodiments, referring to FIG. 18, FIG. 18 is a partial sectional view of the display module 100 according to still some other embodiments of this application. A difference between the display module 100 in this embodiment and the display module 100 in the embodiment shown in FIG. 10 lies in that the buffer layer 1026 in this embodiment is not in direct contact with the electrostatic discharge layer 1025 and the buffer layer 1026 is connected to the electrostatic discharge layer 1025 by using a conductive part 1028. In this embodiment, the first surface 1026a of the buffer layer 1026 is fixedly connected to the electrostatic discharge layer 1025 by using a fifth bonding layer 605, and the conductive part 1028 is connected between the first side wall surface 1026c of the buffer layer 1026 and a side wall surface of the electrostatic discharge layer 1025. Optionally, the conductive part 1028 is a conductive adhesive, conductive silica gel, a conductive foam, or the like. In this way, an electrostatic discharge path can also be formed between the buffer layer 1026, the conductive part 1028, and the electrostatic discharge layer 1025, thereby discharging electrostatic charges conveniently.

It may be understood that, in another embodiment, the conductive part 1028 may alternatively be inserted between the buffer layer 1026 and the electrostatic discharge layer 1025. An electrostatic discharge path can be formed between the buffer part, the conductive part 1028, and the electrostatic discharge layer 1025 provided that the buffer layer 1026 is connected to the electrostatic discharge layer 1025 by using the conductive part 1028, thereby discharging electrostatic charges conveniently.

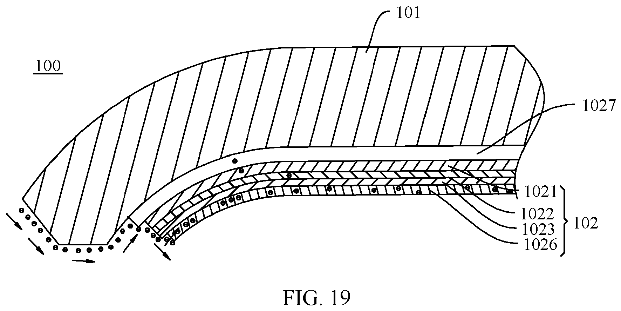

In still some other embodiments, referring to FIG. 19, FIG. 19 is a partial sectional view of the display module 100 according to still some other embodiments of this application. A difference between the display module 100 in this embodiment and the display module 100 in the embodiment shown in FIG. 10 lies in that the buffer layer 1026 of the display module 100 in this embodiment is a conductive member and the buffer layer 1026 is used for grounding. In other words, the buffer layer 1026 in this embodiment not only can be used to buffer impact and protect the display panel 1022, but also can be used to discharge static electricity. In this way, a structure of the display module 100 can be simplified to reduce costs.

In this embodiment, the buffer layer 1026 may include conductive silica gel, conductive rubber, a conductive foam, and the like.

In the description of this specification, specific features, structures, materials, or characteristics may be properly combined in any one or more embodiments or examples.

Finally, it should be noted that the foregoing embodiments are only used to illustrate the technical solutions in this application, but are not used to limit this application. Although this application has been described in detail with reference to the foregoing embodiments, it should be understood by a person of ordinary skill in the art that the technical solutions described in the foregoing embodiments may still be modified, or some technical features thereof may be equivalently replaced, as long as they fall within the scope of protection set in the appended claims.

## Claims

1. A display module (100), comprising:
a display panel (1022), wherein the display panel (1022) has a display side and a non-display side (102b) disposed opposite to each other;
a back plane film (1023), wherein the back plane film (1023) is located on the non-display side (102b) of the display panel (1022); and
a buffer layer (1026), wherein the buffer layer (1026) is located on a side that is of the back plane film (1023) and that is away from the display panel (1022); and
an electrostatic discharge layer (1025), wherein the electrostatic discharge layer (1025) is located on a side that is of the buffer layer (1026) and that is away from the display panel (1022), an impedance of the buffer layer (1026) is less than an impedance of the back plane film (1023), at least a part of a surface of the buffer layer (1026) is in direct contact with the electrostatic discharge layer (1025), and the electrostatic discharge layer (1025) is electrically connected to a grounding point, wherein the buffer layer (1026) is conductive silica gel.

2. A display module (100), comprising:
a display panel (1022), wherein the display panel (1022) has a display side and a non-display side (102b) disposed opposite to each other;
a back plane film (1023), wherein the back plane film (1023) is located on the non-display side (102b) of the display panel (1022); and
a buffer layer (1026), wherein the buffer layer (1026) is located on a side that is of the back plane film (1023) and that is away from the display panel (1022);
an electrostatic discharge layer (1025), wherein the electrostatic discharge layer (1025) is located on a side that is of the buffer layer (1026) and that is away from the display panel (1022), an impedance of the buffer layer (1026) is less than an impedance of the back plane film (1023), and the electrostatic discharge layer (1025) is electrically connected to a grounding point; and
a conductive part (1028), wherein one end of the conductive part (1028) is connected to the buffer layer (1026), and the other end of the conductive part (1028) is connected to the electrostatic discharge layer (1025), wherein the buffer layer (1026) is conductive silica gel.

3. The display module (100) according to claim 1 or 2, wherein at least a part of the surface of the buffer layer (1026) is in direct contact with the back plane film (1023).

4. The display module (100) according to any one of claims 1-3, wherein the buffer layer (1026) has the first surface and the second surface disposed opposite to each other in the thickness direction of the buffer layer (1026), and the second surface is in direct contact with and fastened through bonding to a surface on the side that is of the back plane film (1023) and that is away from the display panel (1022).

5. The display module (100) according to any one of claims 1-4, wherein a concave-convex structure is disposed on a surface on a side that is of the buffer layer (1026) and that faces the back plane film (1023).

6. The display module (100) according to any one of claims 1-5, wherein the impedance of the buffer layer (1026) is greater than an impedance of the electrostatic discharge layer (1025).

7. The display module (100) according to claim 6, wherein the impedance of the buffer layer (1026) is greater than or equal to 10³ Ω and less than or equal to 10⁶ Q.

8. The display module (100) according to any one of claims 1-7, wherein a thickness of the buffer layer (1026) is greater than or equal to 0.05 mm and less than or equal to 0.15 mm.

9. The display module (100) according to claim 8, wherein the thickness of the buffer layer (1026) is greater than or equal to 0.08 mm and less than or equal to 0.12 mm.

10. The display module (100) according to any one of claims 1-9, wherein the electrostatic discharge layer (1025) is a metal layer.

11. The display module (100) according to any one of claims 1-10, further comprising:
a polarizer, wherein the polarizer is located on the display side of the display panel (1022).

12. The display module (100) according to claim 11, further comprising a light-transmissive cover plate, wherein the light-transmissive cover plate is disposed on a side that is of the polarizer and that is away from the display panel (1022), and the light-transmissive cover plate is connected through bonding to the polarizer through a transparent optically clear adhesive.

13. A display apparatus, comprising:
a display module (100), wherein the display module (100) is the display module (100) according to any one of claims 1-12,
a back housing, wherein the back housing comprises a back cover and a frame, the frame is disposed around an edge of the back cover for one circle, the display module (100) is disposed on the back housing, and the display module (100) is disposed opposite to the back cover; wherein the back housing further comprises a middle plate, the middle plate is fixedly connected to an inner surface of the frame;
a circuit board, wherein the circuit board is disposed in the back housing;
a grounding point is disposed on at least one of the middle plate or the circuit board, and the electrostatic discharge layer (1025) is electrically connected to the grounding point.

## Patentansprüche

1. Anzeigemodul (100), umfassend:
ein Anzeigepanel (1022), wobei das Anzeigepanel (1022) eine Anzeigeseite und eine Nicht-Anzeigeseite (102b) aufweist, die einander gegenüberliegend angeordnet sind;
einen Rückseitenfilm (1023), wobei der Rückseitenfilm (1023) auf der Nicht-Anzeigeseite (102b) des Anzeigepanels (1022) angeordnet ist; und
eine Pufferschicht (1026), wobei die Pufferschicht (1026) auf einer Seite des Rückseitenfilms (1023) angeordnet ist, die von dem Anzeigepanel (1022) abgewandt ist; und
eine elektrostatische Entladungsschicht (1025), wobei die elektrostatische Entladungsschicht (1025) auf einer Seite der Pufferschicht (1026) angeordnet ist, die von dem Anzeigepanel (1022) abgewandt ist, wobei eine Impedanz der Pufferschicht (1026) geringer ist als eine Impedanz des Rückseitenfilms (1023), wobei mindestens ein Teil einer Oberfläche der Pufferschicht (1026) in direktem Kontakt mit der elektrostatischen Entladungsschicht (1025) steht und die elektrostatische Entladungsschicht (1025) elektrisch mit einem Erdungspunkt verbunden ist, wobei die Pufferschicht (1026) leitfähiges Silikagel ist.

2. Anzeigemodul (100), umfassend:
ein Anzeigepanel (1022), wobei das Anzeigepanel (1022) eine Anzeigeseite und eine Nicht-Anzeigeseite (102b) aufweist, die einander gegenüberliegend angeordnet sind;
einen Rückseitenfilm (1023), wobei der Rückseitenfilm (1023) auf der Nicht-Anzeigeseite (102b) des Anzeigepanels (1022) angeordnet ist; und
eine Pufferschicht (1026), wobei die Pufferschicht (1026) auf einer Seite des Rückseitenfilms (1023) angeordnet ist, die von dem Anzeigepanel (1022) abgewandt ist;
eine elektrostatische Entladungsschicht (1025), wobei die elektrostatische Entladungsschicht (1025) auf einer Seite der Pufferschicht (1026) angeordnet ist, die von dem Anzeigepanel (1022) abgewandt ist, wobei eine Impedanz der Pufferschicht (1026) geringer ist als eine Impedanz des Rückseitenfilms (1023) und die elektrostatische Entladungsschicht (1025) elektrisch mit einem Erdungspunkt verbunden ist; und
ein leitfähiges Teil (1028), wobei ein Ende des leitfähigen Teils (1028) mit der Pufferschicht (1026) verbunden ist und das andere Ende des leitfähigen Teils (1028) mit der elektrostatischen Entladungsschicht (1025) verbunden ist, wobei die Pufferschicht (1026) leitfähiges Silikagel ist.

3. Anzeigemodul (100) nach Anspruch 1 oder 2, wobei mindestens ein Teil der Oberfläche der Pufferschicht (1026) in direktem Kontakt mit dem Rückseitenfilm (1023) steht.

4. Anzeigemodul (100) nach einem der Ansprüche 1-3, wobei die Pufferschicht (1026) die erste Oberfläche und die zweite Oberfläche aufweist, die in Dickenrichtung der Pufferschicht (1026) einander gegenüberliegend angeordnet sind, und wobei die zweite Oberfläche in direktem Kontakt steht und durch Verkleben an einer Oberfläche auf der Seite der Rückwandfolie (1023) befestigt ist, die vom Anzeigepanel (1022) abgewandt ist.

5. Anzeigemodul (100) nach einem der Ansprüche 1-4, wobei auf einer Oberfläche auf der Seite der Pufferschicht (1026), die der Rückwandfolie (1023) zugewandt ist, eine konkav-konvexe Struktur angeordnet ist.

6. Anzeigemodul (100) nach einem der Ansprüche 1-5, wobei die Impedanz der Pufferschicht (1026) größer als eine Impedanz der elektrostatischen Entladungsschicht (1025) ist.

7. Anzeigemodul (100) nach Anspruch 6, wobei die Impedanz der Pufferschicht (1026) größer oder gleich 10³ Ω und kleiner oder gleich 10⁶ Ω ist.

8. Anzeigemodul (100) nach einem der Ansprüche 1-7, wobei eine Dicke der Pufferschicht (1026) größer oder gleich 0,05 mm und kleiner oder gleich 0,15 mm ist.

9. Anzeigemodul (100) nach Anspruch 8, wobei die Dicke der Pufferschicht (1026) größer oder gleich 0,08 mm und kleiner oder gleich 0,12 mm ist.

10. Anzeigemodul (100) nach einem der Ansprüche 1-9, wobei die elektrostatische Entladungsschicht (1025) eine Metallschicht ist.

11. Anzeigemodul (100) nach einem der Ansprüche 1-10, ferner umfassend:
einen Polarisator, wobei sich der Polarisator auf der Anzeigeseite des Anzeigepanels (1022) befindet.

12. Anzeigemodul (100) nach Anspruch 11, ferner umfassend eine lichtdurchlässige Abdeckplatte, wobei die lichtdurchlässige Abdeckplatte auf einer Seite angeordnet ist, die vom Polarisator und vom Anzeigepanel (1022) abgewandt ist, und wobei die lichtdurchlässige Abdeckplatte durch ein transparentes optisch klares Klebemittel mit dem Polarisator verklebt ist.

13. Anzeigevorrichtung, umfassend:
ein Anzeigemodul (100), wobei das Anzeigemodul (100) das Anzeigemodul (100) nach einem der Ansprüche 1-12 ist,
ein Rückgehäuse, wobei das Rückgehäuse eine Rückabdeckung und einen Rahmen umfasst, wobei der Rahmen um einen Rand der Rückabdeckung herum für einen Kreis angeordnet ist, wobei das Anzeigemodul (100) auf dem Rückgehäuse angeordnet ist und das Anzeigemodul (100) gegenüber der Rückabdeckung angeordnet ist; wobei das Rückgehäuse ferner eine Mittelplatte umfasst, wobei die Mittelplatte fest mit einer Innenfläche des Rahmens verbunden ist;
eine Leiterplatte, wobei die Leiterplatte im hinteren Gehäuse angeordnet ist;
ein Erdungspunkt ist auf mindestens einer der mittleren Platte oder der Leiterplatte angeordnet, und die elektrostatische Entladungsschicht (1025) ist elektrisch mit dem Erdungspunkt verbunden.

## Revendications

1. Module d'affichage (100), comprenant :
un panneau d'affichage (1022), dans lequel le panneau d'affichage (1022) présente un côté affichage et un côté non-affichage (102b) disposés à l'opposé l'un de l'autre ;
un film de fond de panier (1023), dans lequel le film de fond de panier (1023) est situé sur le côté non-affichage (102b) du panneau d'affichage (1022) ; et
une couche tampon (1026), dans laquelle la couche tampon (1026) est située sur un côté du film de fond de panier (1023) qui est à l'opposé du panneau d'affichage (1022) ; et
une couche de décharge électrostatique (1025), dans laquelle la couche de décharge électrostatique (1025) est située sur un côté de la couche tampon (1026) qui est à l'opposé du panneau d'affichage (1022), une impédance de la couche tampon (1026) est inférieure à une impédance du film de fond de panier (1023), au moins une partie d'une surface de la couche tampon (1026) est en contact direct avec la couche de décharge électrostatique (1025), et la couche de décharge électrostatique (1025) est électriquement connectée à un point de mise à la terre, dans laquelle la couche tampon (1026) est un gel de silice conducteur.

2. Module d'affichage (100), comprenant :
un panneau d'affichage (1022), dans lequel le panneau d'affichage (1022) présente un côté affichage et un côté non-affichage (102b) disposés à l'opposé l'un de l'autre ;
un film de fond de panier (1023), dans lequel le film de fond de panier (1023) est situé sur le côté non-affichage (102b) du panneau d'affichage (1022) ; et
une couche tampon (1026), dans laquelle la couche tampon (1026) est située sur un côté du film de fond de panier (1023) qui est à l'opposé du panneau d'affichage (1022) ;
une couche de décharge électrostatique (1025), dans laquelle la couche de décharge électrostatique (1025) est située sur un côté de la couche tampon (1026) qui est à l'opposé du panneau d'affichage (1022), une impédance de la couche tampon (1026) est inférieure à une impédance du film de fond de panier (1023), et la couche de décharge électrostatique (1025) est électriquement connectée à un point de mise à la terre ; et
une partie conductrice (1028), dans laquelle une extrémité de la partie conductrice (1028) est connectée à la couche tampon (1026), et l'autre extrémité de la partie conductrice (1028) est connectée à la couche de décharge électrostatique (1025), dans laquelle la couche tampon (1026) est un gel de silice conducteur.

3. Module d'affichage (100) selon la revendication 1 ou 2, dans lequel au moins une partie de la surface de la couche tampon (1026) est en contact direct avec le film de fond de panier (1023).

4. Le module d'affichage (100) selon l'une quelconque des revendications 1 à 3, dans lequel la couche tampon (1026) présente la première surface et la seconde surface disposées à l'opposé l'une de l'autre dans la direction de l'épaisseur de la couche tampon (1026), et la seconde surface est en contact direct avec et fixée par collage à une surface sur le côté qui est celui du film de fond de panier (1023) et qui est éloigné du panneau d'affichage (1022).

5. Le module d'affichage (100) selon l'une quelconque des revendications 1 à 4, dans lequel une structure concave-convexe est disposée sur une surface sur un côté qui est celui de la couche tampon (1026) et qui fait face au film de fond de panier (1023).

6. Le module d'affichage (100) selon l'une quelconque des revendications 1 à 5, dans lequel l'impédance de la couche tampon (1026) est supérieure à une impédance de la couche de décharge électrostatique (1025).

7. Le module d'affichage (100) selon la revendication 6, dans lequel l'impédance de la couche tampon (1026) est supérieure ou égale à 10³ Ω et inférieure ou égale à 10⁶ Ω.

8. Le module d'affichage (100) selon l'une quelconque des revendications 1 à 7, dans lequel une épaisseur de la couche tampon (1026) est supérieure ou égale à 0,05 mm et inférieure ou égale à 0,15 mm.

9. Le module d'affichage (100) selon la revendication 8, dans lequel l'épaisseur de la couche tampon (1026) est supérieure ou égale à 0,08 mm et inférieure ou égale à 0,12 mm.

10. Le module d'affichage (100) selon l'une quelconque des revendications 1 à 9, dans lequel la couche de décharge électrostatique (1025) est une couche métallique.

11. Le module d'affichage (100) selon l'une quelconque des revendications 1 à 10, comprenant en outre :
un polariseur, dans lequel le polariseur est situé sur le côté affichage du panneau d'affichage (1022).

12. Le module d'affichage (100) selon la revendication 11, comprenant en outre une plaque de recouvrement transmettant la lumière, dans lequel la plaque de recouvrement transmettant la lumière est disposée sur un côté qui est celui du polariseur et qui est éloigné du panneau d'affichage (1022), et la plaque de recouvrement transmettant la lumière est connectée par collage au polariseur par l'intermédiaire d'un adhésif optique transparent.

13. Appareil d'affichage, comprenant :
un module d'affichage (100), dans lequel le module d'affichage (100) est le module d'affichage (100) selon l'une quelconque des revendications 1 à 12,
un boîtier arrière, dans lequel le boîtier arrière comprend un couvercle arrière et un cadre, le cadre est disposé autour d'un bord du couvercle arrière pour faire un cercle, le module d'affichage (100) est disposé sur le boîtier arrière, et le module d'affichage (100) est disposé à l'opposé du couvercle arrière ; dans lequel le boîtier arrière comprend en outre une plaque intermédiaire, la plaque intermédiaire est connectée de manière fixe à une surface interne du cadre ;
une carte de circuit imprimé, dans laquelle la carte de circuit imprimé est disposée dans le boîtier arrière ;
un point de mise à la terre est disposé sur au moins l'un parmi la plaque intermédiaire ou la carte de circuit imprimé, et la couche de décharge électrostatique (1025) est connectée électriquement au point de mise à la terre.
